# EUROPÄISCHE PATENTANMELDUNG

(11) **EP 1 793 231 A2**
(43) Veröffentlichungstag der Anmeldung: **06.06.2007**
(21) Anmeldenummer: 06024901.8
(22) Anmeldetag: 01.12.2006
(51) Int. Cl.: G01R 1/04

(54) **Elektrische Prüfvorrichtung für die Prüfung eines elektrischen Prüflings sowie entsprechendes Verfahren**

(30) Priorität: 05.12.2005 DE 102005058761; 21.11.2006 DE 102006054734
(71) Anmelder: Feinmetall GmbH, 71083 Herrenberg (DE)
(72) Erfinder: Böhm, Gunther, 71154 Nufringen (DE)
(74) Vertreter: Grosse, Rainer

(57) **Zusammenfassung**

Die Erfindung betrifft eine elektrische Prüfvorrichtung (1) für die Prüfung eines elektrischen Prüflings (39), insbesondere Wafers (40), mit einer Prüfmaschine (2) (Prober), in die eine der Berührungskontaktierung des Prüflings (39) dienende Kontakteinrichtung (3) eingesetzt/einsetzbar ist, wobei eine nur radiales Temperaturausgleichspiel zulassende Mittenzentriervorrichtung (24) zur zentralen Ausrichtung von Kontakteinrichtung (3) und Prüfmaschine (2) relativ zueinander vorgesehen ist. Ferner betrifft die Erfindung ein entsprechendes Verfahren.

## Beschreibung

Die Erfindung betrifft eine elektrische Prüfvorrichtung für die Prüfung eines elektrischen Prüflings, insbesondere Wafers, mit einer Prüfmaschine (Prober), in die eine der Berührungskontaktierung des Prüflings dienende Kontakteinrichtung eingesetzt/einsetzbar ist.

Elektrische Prüfvorrichtungen der eingangs genannten Art dienen zur elektrischen Prüfung eines elektrischen Prüflings, beispielsweise eines Wafers. Für die elektrische Prüfung wird in eine Prüfmaschine eine Kontakteinrichtung eingesetzt. Die Kontakteinrichtung besitzt eine Vielzahl von Prüfkontakten, die beispielsweise als Knicknadeln ausgebildet sind. Die freien Enden der Knicknadeln dienen der Berührungskontaktierung des Prüflings. Die Prüfmaschine hat die Aufgabe, den Prüfling so unterhalb der Kontakteinrichtung zu positionieren (X- und Y-Ausrichtung) und den Prüfling derart anzuheben (Z-Positionierung), dass die Knicknadeln mit entsprechenden Kontakten des Prüflings für die Prüfung berührungskontaktieren. Ferner hat die Prüfmaschine die Aufgabe, elektrische Verbindungen zwischen der Kontakteinrichtung und einem Tester herzustellen. Zusätzlich können gegebenenfalls mechanische Verbindungen realisiert werden. Mittels des Testers wird die elektrische Prüfung des Prüflings durchgeführt, das heißt, es werden elektrische Prüfstromkreise zum Prüfling hin aufgebaut, um eine Funktionsprüfung durchzuführen. Die Prüfstromwege verlaufen vom Tester über die Kontakteinrichtung zum Prüfling und von dort aus zurück zum Tester. Da es sich bei den elektrischen Prüflingen oft um extrem kleine elektronische Bauelemente handelt, beispielsweise die erwähnten Wafer, aus denen elektronische Einzelbauelemente gefertigt werden, besitzen die Knicknadeln extrem kleine Abmessungen und die mit den Knicknadeln zu kontaktierenden Kontaktstellen des Prüflings sind ebenfalls sehr klein ausgebildet. Für die Ausrichtung von Kontakteinrichtung und Wafer werden vorzugsweise Kameras zu Hilfe genommen, die die Lage des Wafers auf einem so genannten Prüflingsträgers (Chuck) der Prüfmaschine (Prober) und die Lage der Nadelspitzen der Knicknadeln sehr präzise (auf wenige µm genau) erfassen und hierdurch eine hinreichend genaue Ausrichtung der Bauteile zueinander ermöglichen, sodass bei einer Kontaktierung die Knicknadeln präzise Kontakt zu den Prüflingskontakten erhalten. Viele Prüflinge, beispielsweise Wafer, können in der Regel nicht mit einer einzigen Kontaktierung getestet werden. Meist sind mehrere, häufig Hunderte von Kontaktierungsvorgängen erforderlich, das heißt, der Prüfling wird mittels des Prüflingsträgers zwischen den einzelnen Kontaktierungen verfahren und zur Prüfung jeweils angehoben. Um Prüfzeit zu sparen, wird nicht vor jeder Berührungskontaktierung eine komplette Ausrichtung durchgeführt. Vielmehr wird nach dem Einsetzen der Kontakteinrichtung in die Prüfmaschine die Position der Kontakteinrichtung einmalig erfasst. Beim automatischen Testen vieler Prüflinge, beispielsweise gleich aufgebauter Wafer (zum Beispiel eines Loses mit 25 Stück), werden dann nur noch die Positionen der Wafer auf dem Prüflingsträger erfasst, nicht jedoch erneut die Position der Kontakteinrichtung, also die Position der Kontaktspitzen der Knicknadeln. Es wird dabei davon ausgegangen, dass sich die Position der Nadelspitzen der Kontakteinrichtung über die Dauer des Prüfprozesses nicht verändert. Der Prüfprozess kann jedoch relativ lange dauern, beispielsweise einige Stunden oder auch Tage. Der Prüfling, insbesondere der Wafer, wird beim Test meist temperiert, zum Beispiel auf 90°C, 150°C oder -40°C. Hierdurch wird auch die Kontakteinrichtung entsprechend temperiert. Selbstverständlich wird die Position der Nadelspitzen erst nach einem derartigen Temperiervorgang erfasst, wobei dieser wenige Minuten bis über eine Stunde dauern kann. Regelmäßig tritt dann das Problem auf, dass auch nach dem Temperiervorgang noch "Bewegungen" der Kontakteinrichtung durch Temperaturänderungen stattfinden. Diese Bewegungen können zu Fehlkontaktierungen führen.

Der Erfindung liegt daher die Aufgabe zugrunde, eine elektrische Prüfvorrichtung der eingangs genannten Art zu schaffen, mit der unabhängig von der herrschenden Temperatur eine sichere und reproduzierbare Berührungskontaktierung des Prüflings möglich ist.

Diese Aufgabe wird erfindungsgemäß gelöst durch eine nur radiales Temperaturausgleichsspiel zulassende Mittenzentriervorrichtung zur zentralen Ausrichtung von Kontakteinrichtung und Prüfmaschine relativ zueinander. Diese Art der Aufnahme der Kontakteinrichtung in der Prüfmaschine wirkt sich entscheidend auf das Ausmaß möglicher Temperaturbewegungen aus, da durch Temperaturausgleichsspiel auftretende Längenänderungen nur von dem jeweiligen Zentrum der erwähnten Bauteile ausgehen und jeweils - vom Zentrum her betrachtet - nur in radialer Richtung vorliegen. Nach dem vorzugsweise kameragestützten Ausrichten der Zentren von Kontakteinrichtung und Prüfmaschine relativ zueinander bleiben bei einem Temperaturausgleichsspiel die beiden Zentren positionsgenau zueinander positioniert, sodass im Bereich der Zentren keine oder nur sehr geringe temperaturbedingten Längenveränderungen und damit Lageveränderungen stattfinden und sich diese Veränderungen auch nicht über die gesamte Ausdehnung der Kontakteinrichtung aufaddieren, sondern - wie erwähnt - vom Zentrum ausgehen. Auf diese Art und Weise ist sichergestellt, dass eine einwandfreie elektrische Kontaktierung der Prüfkontakte der Kontakteinrichtung mit den zugehörigen Prüflingskontakten auch bei Temperaturänderungen gewährleistet ist.

Nach einer Weiterbildung der Erfindung ist vorgesehen, dass die Mittenzentriervorrichtung mindestens drei, vorzugsweise vier, winkelversetzt zueinander angeordnete erste Gleitführungen aufweist. Unter "winkelversetzt" ist eine Umfangspositionierung um das entsprechende Zentrum herum zu verstehen. Werden drei erste Gleitführungen eingesetzt, so liegt ein bestimmtes System vor. Bei vier winkelversetzt zueinander liegenden ersten Gleitführungen ist eine Überbestimmung gegeben, dennoch ist eine sichere und reproduzierbare Kontaktierung des Prüflings möglich.

Die ersten Gleitführungen sind vorzugsweise als erste Vorsprungs/Vertiefungs-Führungen ausgebildet. Dies bedeutet insbesondere, dass jede der ersten Gleitführungen durch einen Vorsprung an der Kontakteinrichtung oder der Prüfmaschine und eine den Vorsprung mit radialem Spiel und in Umfangsrichtung spielfrei aufnehmende Vertiefung an der Prüfmaschine oder der Kontakteinrichtung ausgebildet ist. Demzufolge können Vorsprung und zugehörige Vertiefung, die insbesondere als Radialschlitz ausgebildet sein kann, nur vom Zentrum ausgehende radiale Temperaturausgleichsspiele, nicht jedoch in Umfangsrichtung temperaturbedingte Verlagerungen vornehmen.

Nach einer Weiterbildung der Erfindung ist vorgesehen, dass die Kontakteinrichtung einen dem Prüfling zugewandten Kontaktkopf, insbesondere Vertikalkontaktkopf, mit Kontaktelementen und einen Verdrahtungsträger aufweist, der Kontaktflächen besitzt, die mit den dem Prüfling abgewandten Enden der Kontaktelemente in Berührungskontakt stehen, wobei eine nur radiales Temperaturausgleichsspiel zulassende Mittenzentriereinrichtung zur zentralen Ausrichtung von Kontaktkopf und Verdrahtungsträger relativ zueinander vorgesehen ist. Mithin ist neben der Mittenzentriervorrichtung zwischen Kontakteinrichtung und Prüfmaschine ferner eine Mittenzentriervorrichtung vorgesehen, um eine zentrale Ausrichtung von Kontaktkopf und Verdrahtungsträger relativ zueinander zu schaffen, sodass auch dort auftretendes Temperaturausgleichsspiel nur radiale Wirkungen entfalten können. Der Kontaktkopf weist vorzugsweise eine Kontaktstiftanordnung/Kontaktnadelanordnung auf, die die stiftförmgen/nadelförmigen Kontaktelemente besitzt. Insofern bleiben die Kontaktstiftanordnung beziehungsweise Kontaktnadelanordnung und die Kontaktflächen des Verdrahtungsträgers auch bei unterschiedlicher Temperaturbeaufschlagung entsprechend zueinander ausgerichtet, sodass eine sichere, reproduzierbare Kontaktierung gegeben ist.

Nach einer Weiterbildung der Erfindung ist vorgesehen, dass die Mittenzentriereinrichtung außerhalb der Kontaktstiftanordnung/Kontaktnadelanordnung angeordnet ist. Diese Ausgestaltung gestattet es, den Bereich der Kontaktstiftanordnung beziehungsweise Kontaktnadelanordnung von den Zentriermitteln freizuhalten, sodass das Gebiet um das jeweilige Zentrum von Kontaktkopf und Verdrahtungsträger nur für die Aufnahme von stiftförmigen Kontaktelementen, insbesondere Nadeln, vorzugsweise Knicknadeln, zur Verfügung steht.

Vorzugsweise ist vorgesehen, dass die Mittenzentriereinrichtung mindestens drei, insbesondere vier, winkelversetzt zueinander angeordnete zweite Gleitführungen aufweist. Bei drei Gleitführungen können diese insbesondere um 120° zueinander winkelversetzt liegen. Dies gilt sowohl für die ersten Gleitführungen als auch für die zweiten Gleitführungen. Alternativ ist es möglich, dass benachbarte Gleitführungen 90° Winkel zueinander einschließen, das heißt eine erste zweite Gleitführung weist zu einer zweiten zweite Gleitführung einen Winkel von 90° und die zweite zweite Gleitführung mit einer dritten zweiten Gleitführung ebenfalls ein Winkel von 90° auf, sodass die dritte zweite Gleitführung zur ersten zweiten Gleitführung 180° winkelversetzt liegt. Entsprechendes kann für die ersten Gleitführungen gelten, die der zentralen Ausrichtung von Kontakteinrichtung und Prüfmaschine relativ zueinander dienen. Alternativ kann bei vier Gleitführungen vorgesehen sein, dass diese jeweils zueinander um 90° winkelversetzt liegen. Dies gilt sowohl für die ersten Gleitführungen als auch für die zweiten Gleitführungen, wobei die zweiten Gleitführungen der Positionierung von Kontaktkopf und Verdrahtungsträger relativ zueinander dienen.

Die zweiten Gleitführungen sind bevorzugt als zweite Vorsprungs/Vertiefungs-Führungen ausgebildet. Hierbei kann insbesondere vorgesehen sein, dass jede der zweiten Gleitführungen durch einen Vorsprung an dem Kontaktkopf oder an dem Verdrahtungsträger und eine den Vorsprung mit radialem Spiel und in Umfangsrichtung spielfrei aufnehmende Vertiefung, insbesondere Schlitz, an dem Verdrahtungsträger oder dem Kontaktkopf gebildet ist.

Die Kontakteinrichtung kann insbesondere als Prüfkarte ausgebildet sein. Bevorzugt ist die Ausbildung der Prüfkarte als Vertikal-Prüfkarte, das heißt, sie weist Prüfkontakte, insbesondere Nadeln oder Knicknadeln, auf, die zur Prüfebene einen Winkel von 90° oder etwa 90° einschließen. Unter Prüfebene ist die Kontaktebene zu verstehen, also die Schnittstelle zwischen Prüfling und Kontaktkopf. Letzterer dient der elektrischen Berührungskontaktierung des Prüflings, wobei die Prüfkontakte bevorzugt stiftförmig/nadelförmig ausgebildet sind und in Längsrichtung verschieblich im Kontaktkopf gehalten werden.

Schließlich betrifft die Erfindung ein Verfahren zur Prüfung eines elektrischen Prüflings, insbesondere Wafers, wobei bevorzugt eine elektrische Kontakteinrichtung - wie vorstehend beschrieben - eingesetzt wird. Es ist dabei der Einsatz einer Prüfmaschine (Prober) vorgesehen, in die eine der Berührungskontaktierung des Prüflings dienende Kontakteinrichtung, bevorzugt Prüfkarte, eingesetzt ist/eingesetzt wird, und wobei zur zentralen Ausrichtung von Kontakteinrichtung und Prüfmaschine relativ zueinander eine nur radiales Temperaturausgleichsspiel zulassende Mittenzentrierung erfolgt. Temperaturausgleichsspiel in Umfangsrichtung ist nicht möglich.

Die Zeichnungen veranschaulichen die Erfindung anhand von Ausführungsbeispielen, und zwar zeigt:
- Figur 1: einen Querschnitt durch eine elektrische Prüfvorrichtung für die Prüfung eines elektrischen Prüflings,
- Figuren 2 und 3: Ausführungsbeispiele einer Mittenzentriervorrichtung für eine zentrale Ausrichtung von jeweils der Prüfvorrichtung angehörender Kontakteinrichtung und Prüfmaschine relativ zueinander,

- Figur 4: eine der Mittenzentrierung dienende erste Gleitführung mit Vorsprung und Vertiefung,
- Figur 5: ein anderes Ausführungsbeispiel eines Vorsprungs,
- Figur 6: eine Kontakteinrichtung der elektrischen Prüfvorrichtung zur Kontaktierung des Prüflings und
- Figur 7: eine Mittenzentriereinrichtung der Kontakteinrichtung zur zentralen Ausrichtung von jeweils der Kontakteinrichtung angehörendem Kontaktkopf und Verdrahtungsträger relativ zueinander.

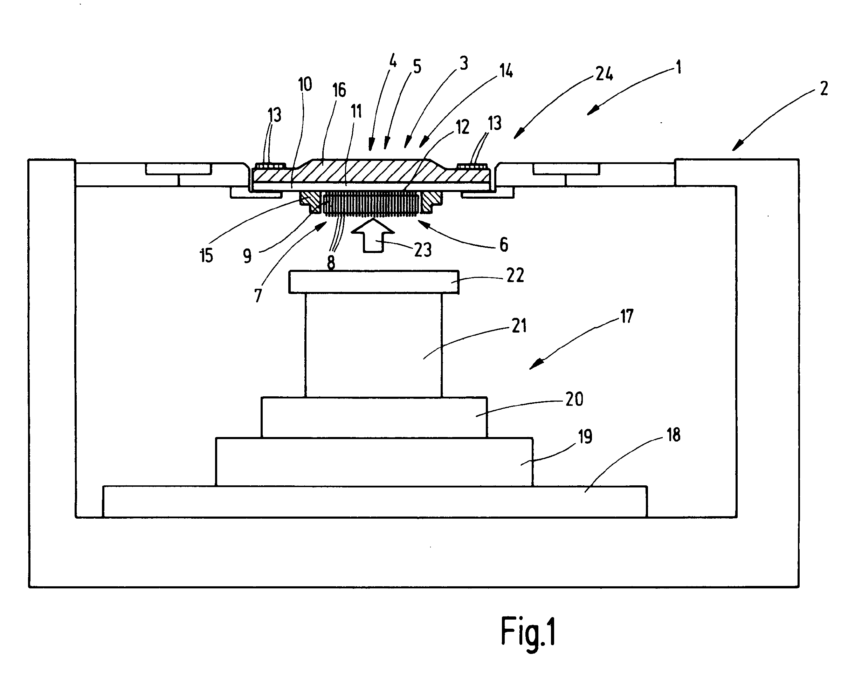

Die Figur 1 zeigt eine elektrische Prüfvorrichtung 1, die der Prüfung eines aus der Figur 1 nicht hervorgehenden Prüflings dient. Die Prüfvorrichtung 1 weist eine Prüfmaschine 2 (Prober) auf, in die eine Kontakteinrichtung 3 einsetzbar ist. Die Kontakteinrichtung 3 wird im Wesentlichen horizontal sowie durch leichtes Absenken von oben in die Prüfmaschine 2 eingesetzt. Sie ist als Prüfkarte 4, insbesondere Vertikal-Prüfkarte 5 ausgebildet. Letzteres bedeutet, dass sie in einem Kontaktkopf 6 eine Vielzahl von Prüfkontakten 7 aufweist, die als Nadeln, insbesondere Knicknadeln 8 ausgebildet sind, die quer, insbesondere vertikal, zur vorzugsweise horizontalen Prüfebene verlaufen. "Knicknadeln" bedeutet, dass diese jeweils eine leichte Durchbiegung aufweisen, sie also von einer geradlinigen Form abweichen. Die Durchbiegung kann beispielsweise durch versetzt liegende Halteöffnungen einer Führung 9 hervorgerufen werden, in denen die Knicknadeln längsverschieblich lagern. Wird der Prüfling gegen die vorzugsweise spitz auslaufenden freien Enden der Knicknadeln gedrängt, so können diese aufgrund der Durchbiegung leicht ausfedern und hierdurch Abstandsunregelmäßigkeiten ausgleichen und sehr gut kontaktieren.

Wie bereits vorstehend erwähnt, werden die Knicknadeln 8 in der Führung 9 gehalten, wobei die einen Enden der Knicknadeln 8 freie Enden bilden, die dem Berührungskontaktieren des Prüflings dienen. Die anderen Enden der Knicknadeln 8 liegen an Kontakten 12 eines Verdrahtungsträgers 10, vorzugsweise einer Leiterplatte 11, an. Die erwähnten Kontakte 12 der Leiterplatte 11 sind mit auf der anderen Seite der Leiterplatte 11 liegenden Kontakten 13 verbunden, beispielsweise über Leiterbahnen 41 der Leiterplatte 11. Die Kontakte 13 werden an einen Tester angeschlossen, der in der Figur 1 nicht gezeigt ist und der dazu dient, Prüfstromwege zum Prüfling durchzuschalten, um den Prüfling auf elektrische Funktionsfähigkeit zu prüfen. Während die von den Knicknadeln 8 berührten Kontakte 12 der Leiterplatte 11 extrem eng beieinander liegen, können die Kontakte 13 über eine weitaus größere Fläche verteilt angeordnet werden, sodass der Anschluss des Testers problemlos möglich ist. Zur Versteifung der Kontakteinrichtung 3 ist eine Versteifungseinrichtung 14, bestehend aus einer vorderen Versteifung 15 und einer hinteren Versteifung 16 vorgesehen. Die Versteifungseinrichtung 14 dient dazu, den Kontaktdruck aufzunehmen, der entsteht, wenn der Prüfling - wie nachstehend noch näher beschrieben werden wird - gegen die Knicknadeln 8 zur Berührungskontaktierung gedrängt wird.

Die Prüfmaschine 2 weist einen Prüflingsträger 17 (Chuck) auf, der eine feststehende Basisplatte 18 besitzt. Ferner gehört zum Prüflingsträger 17 eine Y-Positioniereinrichtung 19, eine X-Positioniereinrichtung 20 und eine Z-Positioniereinrichtung 21. Auf der Z-Positioniereinrichtung 21 ist eine Vakuumhalterung 22 angeordnet, mit der der Prüfling durch Unterdruck positionsunveränderlich gegenüber der Vakuumhalterung 22 gehalten werden kann. Wird nun der Prüfling, beispielsweise ein Wafer, flächig auf die Vakuumhalterung 22 gelegt und durch Unterdruck gehalten, so kann er mittels der X- und Y-Positioniereinrichtungen 20 und 19 und unter Zuhilfenahme von Kameras positionsgenau unterhalb der Kontakteinrichtung 3 derart positioniert werden, dass beim Berührungskontaktieren die Knicknadeln 8 positionsgenau entsprechende Kontakte des Prüflings kontaktieren. Für die Kontaktierung fährt die Z-Positioniereinrichtung 21 nach oben und drängt den Prüfling gegen die freien Enden der Knicknadeln 8. Diese Bewegung ist in der Figur 1 mittels eines Pfeiles 23 angedeutet.

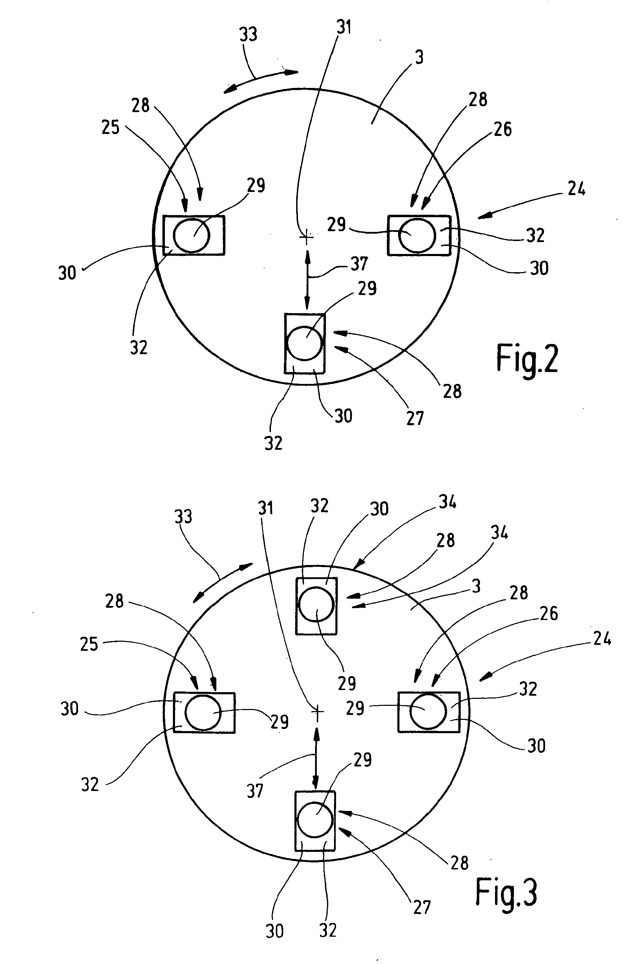

Um die Kontakteinrichtung 3 positionsgenau in der Prüfmaschine 2 zu halten, ist eine Mittenzentriervorrichtung 24 vorgesehen, die dafür sorgt, dass Kontakteinrichtung 3 und Prüfmaschine 2 relativ zueinander zentral ausgerichtet werden. Hierzu wird auf die Figur 2 verwiesen. Diese zeigt eine schematische Draufsicht auf die Kontakteinrichtung 3. Die erwähnte Mittenzentriervorrichtung 24 weist drei winkelversetzt zueinander angeordnete erste radiale Gleitführungen 25, 26 und 27 auf. Die ersten Gleitführungen 25 bis 27 sind als erste Vorsprungs/Vertiefungs-Führungen 28 ausgebildet. Jede erste VorsprungsNertiefungs-Führung besitzt einen Vorsprung 29, der der Prüfmaschine 2 angehört. Die Vorsprünge 29 weisen zum Beispiel einen kreisförmigen Querschnitt auf und liegen mit radialem Spiel und in Umfangsrichtung spielfrei jeweils in einer zugehörigen radialen Vertiefung 30 ein, wobei die Vertiefungen 30, die auch als Schlitze und/oder Durchbrüche ausgebildet sein können, an der Kontakteinrichtung 3 ausgebildet sind. Zur ersten Gleitführung 25 liegt um 90° versetzt die erste Gleitführung 26 und zu dieser wiederum um 90° versetzt die erste Gleitführung 27. Alle Gleitführungen 25 bis 27 sind um ein Zentrum 31 der Kontakteinrichtung 3 beziehungsweise der Prüfmaschine 2 mit radial vorzugsweise gleichem Abstand angeordnet. Die Vertiefungen 30 sind als radial verlaufende Langlöcher 32 beziehungsweise entsprechend gestaltete Schlitze ausgebildet, wobei sich das Wort "radial" auf das Zentrum 31 bezieht. Die Querschnittsformen der Vorsprünge 29 ist - wie erläutert - derart gewählt, dass diese in Umfangsrichtung (Doppelpfeil 33) spielfrei in den Langlöchern 30 einliegen, wobei jedoch in radialer Richtung Spiel aufgrund der radialen Erstreckung der Vertiefungen 30 (Langlöcher 32) besteht.

Aus alledem wird deutlich, dass die erwähnte Mittenzentriervorrichtung 24 eine unverschiebbare Ausrichtung im Bereich des Zentrums 31 zwischen Prüfmaschine 2 und Kontakteinrichtung 3 vornimmt. Selbst wenn durch Temperaturänderung ein Temperaturausgleichsspiel auftritt, weil der Temperaturausdehnungskoeffizient der Prüfmaschine 2 von dem Temperaturausdehnungskoeffizient der Kontakteinrichtung 3 abweicht, bleibt es bei der zentralen Ausrichtung von Kontakteinrichtung 3 und Prüfmaschine 2 relativ zueinander, da ein Temperaturausdehnungsspiel beziehungsweise Temperaturzusammenziehspiel nur relativ zwischen den genannten Bauteilen stattfinden würde, das heißt, es könnte zu einer jedoch geringen radialen Verlagerung der Vorsprünge 29 in den Vertiefungen 30 kommen, ohne dass dabei jedoch die Ausrichtung im Hinblick des Zentrums 31 verändert wird. Unkontrollierte Spannungen oder eine unzulässig große temperaturbedingte Verlagerung der Bauteile werden aufgrund der erfindungsgemäßen Ausgestaltung somit vermieden. Damit führen Temperaturausdehnungen oder Temperaturzusammenziehungen der Kontakteinrichtung 3 relativ zur Prüfmaschine 2 nicht zu einer Veränderung der Position in dem Mittenbereich der Kontakteinrichtung 3 relativ zur Prüfmaschine 2. Aufgrund dieser Ausgestaltung ist auch ein Aufsummieren von temperaturbedingten Längenänderungen beschränkt, da ein Aufsummieren lediglich vom Zentrum 31 aus zu betrachten ist und nicht über den gesamten Durchmesser der Kontakteinrichtung 3.

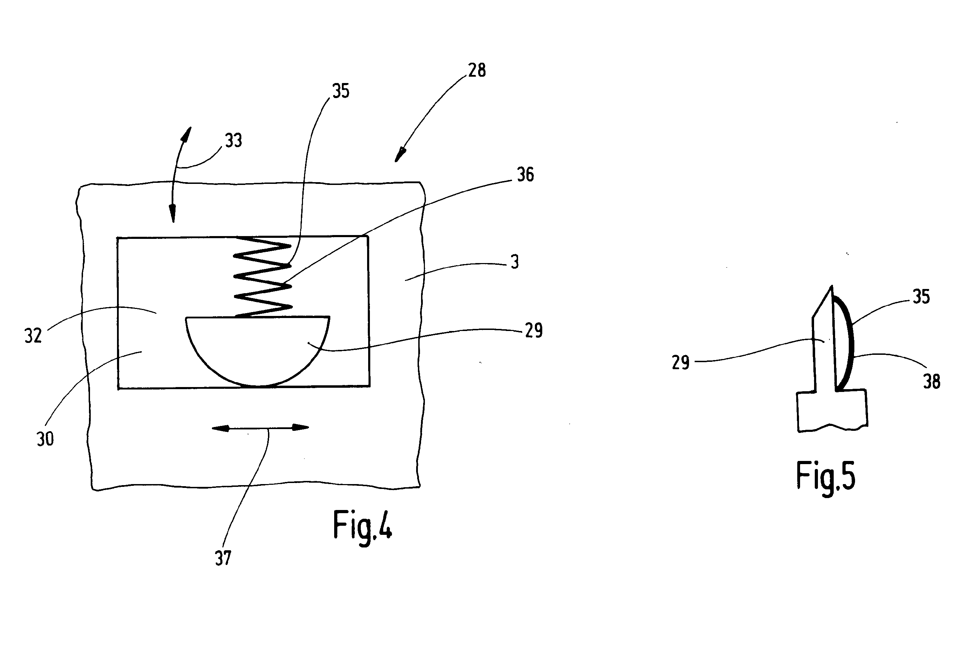

Während man die Ausführungsform der Figur 2 als eine Drei-Schlitz-Anordnung bezeichnen kann, liegt bei der Ausführungsform der Figur 3 eine Vier-Schlitz-Anordnung vor. Der Unterschied zwischen dem Ausführungsbeispiel der Figur 3 und dem Ausführungsbeispiel der Figur 4 besteht darin, dass eine weitere erste radiale Gleitführung 34 vorgesehen ist, sodass die Gleitführungen 25, 26, 27 und 34 jeweils um 90° relativ zueinander versetzt liegen. Im Übrigen gelten die Ausführungen zur Figur 2 entsprechend auch für die Figur 3. Beim Ausführungsbeispiel der Figur 2 liegt ein bestimmtes System, beim Ausführungsbeispiel der Figur 3 liegt ein überbestimmtes System vor, wobei sich jedoch in der Praxis gezeigt hat, dass auch bei dem überbestimmten System die Funktion der Mittenzentrierung nicht nachteilig beeinflusst wird. Vielmehr ist eine etwas höhere Stabilität gegeben und es werden unvermeidbare Toleranzen der Stift-Langloch-Gleitführungen 25, 26, 27 und 34 durch leichtes Verspannen ausgeglichen.

Aus den Ausführungen zu den Figuren 2 und 3 ergibt sich, dass die Mittenzentriervorrichtungen 24 auch kinematisch umgekehrt ausgestattet sein können, das heißt, die Vorsprünge 29 können sich an der Kontakteinrichtung 3 und die Vertiefungen 30 an der Prüfmaschine 2 befinden. Auch sind Mischformen möglich, das heißt die Vorsprünge 29 befinden sich teilweise an der Kontakteinrichtung 3 und teilweise an der Prüfmaschine 2 und entsprechend sind die Vertiefungen 30 verteilt angeordnet.

Bei den Ausführungsbeispielen der Figuren 2 und 3 liegen die Vorsprünge 29 - in Umfangsrichtung (Doppelpfeil 33) gesehen - spielfrei in den Vertiefungen 29 ein. Hierbei ist zu berücksichtigen, dass ein sehr kleines Restspiel dennoch vorhanden sein muss, damit die Vorsprünge 29 sich in den Vertiefungen 30 nicht verklemmen. Um nun auch dieses geringfügige Restspiel zu beseitigen, können Vorsprünge 29 gemäß der Ausführungsbeispiele der Figuren 4 oder 5 eingesetzt werden. Beim Ausführungsbeispiel der Figur 4 weist der jeweilige Vorsprung 29 eine Querschnittskonfiguration auf, die nur an einer Seite der Vertiefung 30 anliegt. Vom Vorsprung 29 geht eine Feder 35 aus, die insbesondere als Schraubendruckfeder 36 ausgebildet ist, und sich an der anderen Seite der Vertiefung 30 abstützt. Auf diese Art und Weise wird eine vollkommene Spielfreiheit in Umfangsrichtung (Doppelpfeil 33) erzielt. In radialer Richtung (Doppelpfeil 37) ist Spiel vorhanden, sodass eine relative Verlagerung von Vorsprung 29 und Vertiefung 30 erfolgen kann.

Alternativ zur Ausführungsform des Vorsprungs 29 in der Figur 4 zeigt die Figur 5 einen Stift 29 in Seitenansicht. Dieser weist als Feder 35 eine Bügelfeder 38 auf, die sich zumindest über einen Teilbereich der Längserstreckung des Vorsprungs 29 erstreckt und sich entsprechend wie die Schraubendruckfeder 36 der Figur 4 an einer Seite der in Figur 5 nicht dargestellten Vertiefung 30 abstützen kann. Die Bügelfeder 38 kann auch als Blattfeder ausgebildet sein.

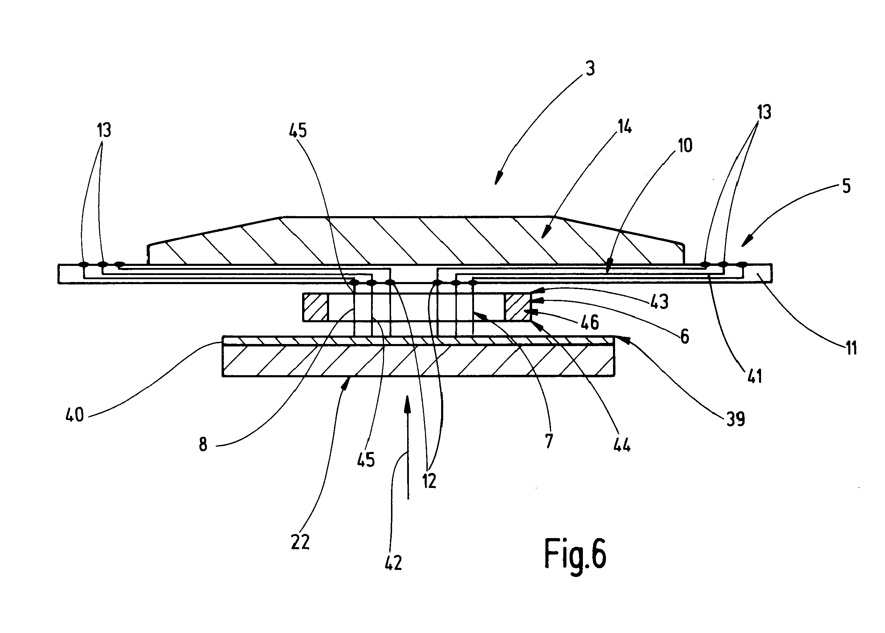

Die Figur 6 zeigt in schematischer Darstellung einen Querschnitt durch die Kontakteinrichtung 3, die zur Kontaktierung des Prüflings 39 mittels nicht dargestellter Kabelverbindungen an einen nicht dargestellten Tester (Prüfsystem) angeschlossen werden kann, um den Prüfling 39 einer elektrischen Prüfung zu unterziehen. Der Prüfling 39 kann insbesondere als Wafer 40 ausgebildet sein, der sich auf der Vakuumhalterung 22 befindet. Während der Prüfung des Prüflings 39 kann dieser unterschiedlichen Temperaturen ausgesetzt werden, die beispielsweise einen Bereich von -40°C bis +150°C umfassen, um zu prüfen, ob der Prüfling auch in diesem Temperaturbereich einwandfrei arbeitet. Zur Kontaktierung entsprechender Anschlussstellen des Wafers 40 ist die Kontakteinrichtung 3 vorgesehen, die als Vertikal-Prüfkarte 5 ausgebildet ist.

Die Kontakteinrichtung 3 weist den Kontaktkopf 6 auf. Zur Aufnahme von Kontaktierungskräften weist die Kontakteinrichtung 3 die Versteifungseinrichtung 14 auf. Der Kontaktkopf 6 ist mit einer Vielzahl von längsverschieblich gelagerten Prüfkontakten 7 versehen, die als Knicknadeln 8 ausgebildet sind, die auch als Knickdrähte bezeichnet werden können. Die Knicknadeln 8 sind mit ihren einen Endbereichen dem Prüfling 39 und mit ihren anderen Endbereichen dem Verdrahtungsträger 10 zugeordnet, der als vorzugsweise mehrlagige Leiterplatte 11 mit Leiterbahnen 41 ausgebildet ist. Die Leiterbahnen 41 weisen an ihren dem Kontaktkopf 6 zugeordneten Enden die Kontakte 12 auf, die den jeweiligen Knicknadeln 8 zugeordnet sind. Ferner besitzt der Verdrahtungsträger 10 an seinem radial außen liegenden Rand elektrische Kontakte 13, die über die erwähnten, nicht dargestellten Kabelverbindungen mit dem Prüfsystem (ebenfalls nicht dargestellt) verbindbar sind. Die Anordnung ist nun derart getroffen, dass der Verdrahtungsträger 10 eine Umsetzvorrichtung bildet, das heißt, der sehr enge Abstand der winzig kleinen Kontakte 12 (Durchmesser zum Beispiel 50 bis 300 µm) wird über die Leiterbahnen 41 in größere Abstände der Kontakte 13 umgesetzt. Die Kontakte 13 haben eine entsprechende Größe, um die Verbindung mit den Kabeln des Testers herstellen zu können.

Bei der Prüfung des Prüflings 39 bewegt sich dieser - abgestützt durch die Versteifungseinrichtung 14 - in axialer Richtung (Pfeil 42), wobei die Vakuumhalterung 22 den Prüfling 39 hält, auf den Kontaktkopf 6 zu, sodass die Stirnenden der Prüfkontakte 7 einerseits auf den Prüfling 39 und andererseits auf die Kontakte 12 auftreffen. Da die Prüfkontakte 7 als Knicknadeln 8 ausgebildet sind, das heißt in axialer Richtung durch Durchbiegung leicht federnd gestaltet sind, ist eine einwandfreie Kontaktierung möglich. Der Kontaktkopf 6 besitzt beispielsweise zwei mit Abstand zueinander liegende parallele Keramikplatten 43 und 44, die mit Lagerbohrungen 45 zur Aufnahme der Knicknadeln 9 versehen sind. Die parallele Abstandslage der beiden Keramikplatten 43 und 44 wird mittels eines Abstandshalters 46 realisiert.

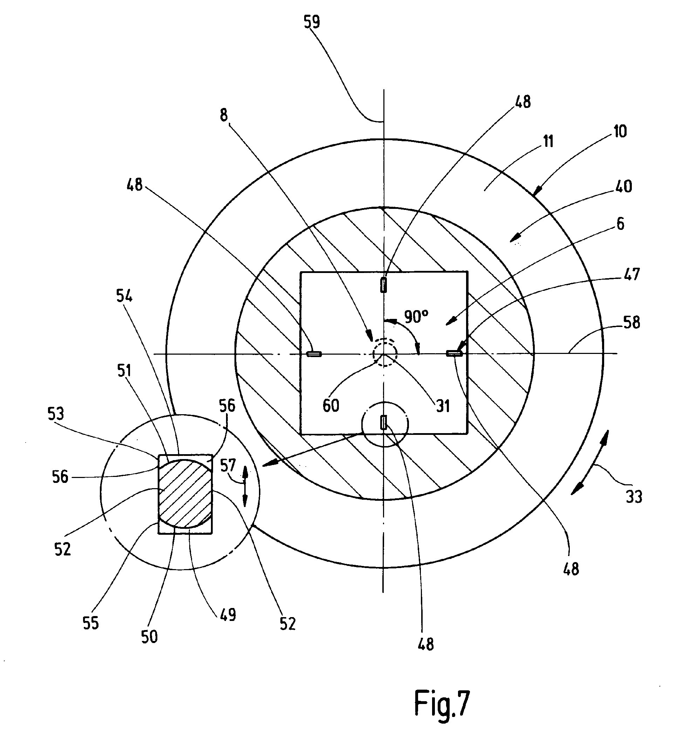

Zwischen Kontaktkopf 6 und Verdrahtungsträger 10 ist eine Mittenzentriereinrichtung 47 vorgesehen (Figur 7), die vier in Umfangsrichtung (Doppelpfeil 33) mit einem Winkelabstand von 90° zueinander versetzt liegende zweite radiale Gleitführungen 48 aufweist. Die Figur 7 lässt erkennen, dass der Prüfling 39, also der Wafer 40, als Kreisplatte ausgebildet ist. Er weist beispielsweise nicht dargestellte integrierte Schaltkreise auf. Um die Schaltkreise elektrisch zu prüfen, wird der vorzugsweise im Grundriss quadratisch ausgebildete Kontaktkopf 6 mit seinen aus der Figur 7 nicht im Einzelnen hervorgehenden Knicknadeln 8 in verschiedenen Positionen mehrfach mit dem Wafer 40 berührungskontaktiert, um jeweils einen entsprechenden Bereich des Wafers 40 prüfen zu können. Natürlich ist auch ein kreisförmiger oder rechteckförmiger Grundriss denkbar. Die in der Figur 7 unten liegende zweite Gleitführung 48 ist vergrößert herausgezeichnet. Sie weist einen Vorsprung 49 in Form eines Profilstiftes 50 auf, der in axialer Richtung (in Richtung des Pfeils 42 in Figur 6) aus dem Kontaktkopf 6 herausragt. Der Profilstift 50 weist an seiner Mantelfläche 51 zwei, einander diametral gegenüberliegende, parallele, ebene Führungsflächen 52 auf. Der Profilstift 50 erstreckt sich mit seinem freien Ende bis in eine Vertiefung 53 hinein, die an dem Verdrahtungsträger 10, also der Leiterplatte 11, ausgebildet ist. Die Vertiefung 53 ist bevorzugt als Durchbruch 54 der Leiterplatte 11 ausgestaltet. Die Vertiefung 53 besitzt eine radiale Langlochform, stellt also ein Langloch 55 dar. Die Vertiefung 53 weist zwei parallel zueinander verlaufende Vertiefungswandungen 56 auf, die derart beabstandet zueinander liegen, dass sie die Führungsflächen 52 des Profilstiftes 50 im Wesentlichen spielfrei aufnehmen. Die Längserstreckung des Langlochs 55 ist größer ausgestaltet als die dementsprechende Längsabmessung des Vorsprungs 49, sodass zwischen Kontaktkopf 6 und Verdrahtungsträger 10, also der Leiterplatte 11, gemäß der vergrößerten Darstellung der Figur 7 eine Relativbewegung in Richtung des eingezeichneten Doppelpfeils 57 stattfinden kann. Quer dazu ist eine Relativbewegung nicht möglich, da dies durch die Führung der Führungsflächen 52 an den Vertiefungswandungen 56 verhindert ist. Alternativ zu der dargestellten Anordnung kann der Profilstift 50 aus der Leiterplatte 11 herausragen und die Vertiefung 53 im Kontaktkopf 6 ausgebildet sein.

Aus der Figur 7 wird deutlich, dass vier zweite Gleitführungen 48 derart angeordnet sind, dass sie auf zwei sich unter einem Winkel von 90° kreuzenden, gedachten Radialen 58 und 59 liegen, wobei sich die Radialen 58 und 59 in einem Mittelpunkt 60 kreuzen und der Mittelpunkt 60 das Zentrum 31 der Kontakteinrichtung 3 bildet. Um das Zentrum 31 sind die Knicknadeln 8 angeordnet. Die vier zweiten Gleitführungen 48 befinden sich radial außen liegend von den Knicknadeln 8, wobei die Längserstreckungen der Langlöcher 55 derart orientiert sind, dass sie jeweils mittig auf den Radialen 58 und 59 liegen. Entsprechend der Langlochausrichtung der Langlöcher 55 sind die Führungsflächen 52 der einzelnen Profilstifte 50 ausgestaltet.

Aus alledem wird deutlich, dass bei einer durch Temperaturbeaufschlagung entstehenden Materialausdehnung beziehungsweise Materialschrumpfung die Bauteile Kontaktkopf 6 und Verdrahtungsträger 10 aufgrund der Mittenzentriereinrichtung 47 im Bereich des Zentrums 31 zueinander fixiert sind und Relativbewegungen nur in Richtung der Radialen 58 und 59 erfolgen können. Hierdurch ist sichergestellt, dass die erwähnten Längenänderungen, die aus unterschiedlichen Temperaturausdehnungskoeffizienten der verwendeten Materialien der Bauteile resultieren, nicht dazu führen können, dass derart große Versatzstrecken auftreten, dass die der Leiterplatte 11 zugeordneten Stirnenden der Knicknadeln 8 nicht mehr auf die Kontaktflächen der Kontakte 12 treffen. Die Mittenzentrierung aufgrund der Mittenzentriereinrichtung 47 verhindert derart große Versatzstrecken, da die auftretenden Längenänderungen vom Zentrum 31 ausgehend beginnen und somit symmetrisch zur Mitte liegen und damit - in radialer Richtung gesehen - nur halb so groß sind, wie ein Versatz, der - bei Nichtverwendung der Mittenzentriereinrichtung - auftreten könnte, wenn außen liegende Knicknadeln 8 zentral auf zugeordnete Kontakte 12 aufsetzen, sodass die diametral gegenüberliegenden, ebenfalls außen liegenden Knicknadeln 8 aufgrund der sich aufsummierenden Längenausdehnungen beziehungsweise Längenschrumpfungen zu Fehlkontakten führen.

## Patentansprüche

1. Elektrische Prüfvorrichtung für die Prüfung eines elektrischen Prüflings, insbesondere Wafers, mit einer Prüfmaschine (Prober), in die eine der Berührungskontaktierung des Prüflings dienende Kontakteinrichtung eingesetzt/einsetzbar ist, **gekennzeichnet durch** eine nur radiales Temperaturausgleichspiel zulassende Mittenzentriervorrichtung (24) zur zentralen Ausrichtung von Kontakteinrichtung (3) und Prüfmaschine (2) relativ zueinander.

2. Prüfvorrichtung nach Anspruch 1, **dadurch gekennzeichnet, dass** die Mittenzentriervorrichtung (24) mindestens drei, vorzugsweise vier, winkelversetzt zueinander angeordnete erste Gleitführungen (25,26,27,34) aufweist.

3. Prüfvorrichtung nach einem der vorhergehenden Ansprüche, **dadurch gekennzeichnet, dass** die ersten Gleitführungen (25,26,27,34) erste Vorsprungs/Vertiefungs-Führungen (28) sind.

4. Prüfvorrichtung nach einem der vorhergehenden Ansprüche, **dadurch gekennzeichnet, dass** jede der ersten Gleitführungen (25,26,27,34) durch einen Vorsprung (29) an der Kontakteinrichtung (3) oder der Prüfmaschine (2) und eine den Vorsprung (29) mit radialem Spiel und in Umfangsrichtung spielfrei aufnehmende Vertiefung (30) an der Prüfmaschine (2) oder der Kontakteinrichtung (3) gebildet ist.

5. Prüfvorrichtung nach einem der vorhergehenden Ansprüche, **dadurch gekennzeichnet, dass** die Kontakteinrichtung (3) einen Kontaktkopf (6), insbesondere Vertikalkontaktkopf, mit Kontaktelementen und einen Verdrahtungsträger (10) aufweist, der Kontaktflächen besitzt, die mit den, dem Prüfling (39) abgewandten Enden der Kontaktelemente in Berührungskontakt stehen, und mit einer nur radiales Temperaturausgleichsspiel zulassende Mittenzentriereinrichtung (47) zur zentralen Ausrichtung von Kontaktkopf (6) und Verdrahtungsträger (10) relativ zueinander.

6. Prüfvorrichtung nach einem der vorhergehenden Ansprüche, **dadurch gekennzeichnet, dass** die Kontaktelemente des Kontaktkopfs (6) eine Kontaktstiftanordnung/Kontaktnadelanordnung bilden und stiftförmig/nadelförmig ausgebildet sind.

7. Prüfvorrichtung nach einem der vorhergehenden Ansprüche, **dadurch gekennzeichnet, dass** die Mittenzentriereinrichtung (47) außerhalb der Kontaktstiftanordnung/Kontaktnadelanordnung angeordnet ist.

8. Prüfvorrichtung nach einem der vorhergehenden Ansprüche, **dadurch gekennzeichnet, dass** die Mittenzentriereinrichtung (47) mindestens drei, insbesondere vier, winkelversetzt zueinander angeordnete zweite Gleitführungen (48) aufweist.

9. Prüfvorrichtung nach einem der vorhergehenden Ansprüche, **dadurch gekennzeichnet, dass** die zweiten Gleitführungen (48) zweite Vorsprungs/Vertiefungs-Führungen sind.

10. Prüfvorrichtung nach einem der vorhergehenden Ansprüche, **dadurch gekennzeichnet, dass** jede der zweiten Gleitführungen (48) durch einen Vorsprung (49) an dem Kontaktkopf (6) oder dem Verdrahtungsträger (10) und eine den Vorsprung (49) mit radialem Spiel und in Umfangsrichtung spielfrei aufnehmende Vertiefung (53) an dem Verdrahtungsträger (10) oder dem Kontaktkopf (6) gebildet ist.

11. Prüfvorrichtung nach einem der vorhergehenden Ansprüche, **dadurch gekennzeichnet, dass** die Kontakteinrichtung (3) eine Prüfkarte ist.

12. Prüfvorrichtung nach einem der vorhergehenden Ansprüche, **dadurch gekennzeichnet, dass** die Prüfkarte als Vertikal-Prüfkarte ausgebildet ist.

13. Prüfvorrichtung nach einem der vorhergehenden Ansprüche, **dadurch gekennzeichnet, dass** zur elektrischen Berührungskontaktierung der Kontaktkopf (6) vorgesehen ist.

14. Prüfvorrichtung nach einem der vorhergehenden Ansprüche, **dadurch gekennzeichnet, dass** der Kontaktkopf (6) Prüfkontakte (7) aufweist, die als Nadeln, insbesondere Knicknadeln (8), ausgebildet sind.

15. Verfahren zur Prüfung eines elektrischen Prüflings, insbesondere Wafers, vorzugsweise mittels einer elektrischen Prüfvorrichtung nach einem oder mehreren der vorherigen Ansprüchen, wobei eine Prüfmaschine (Prober) verwendet wird, in die eine der Berührungskontaktierung des Prüflings dienende Kontakteinrichtung eingesetzt ist/eingesetzt wird, und wobei zur zentralen Ausrichtung von Kontakteinrichtung und Prüfmaschine relativ zueinander eine nur radiales Temperaturausgleichspiel zulassende Mittenzentrierung erfolgt.
